Europäisches Patentamt

European Patent Office

Office européen des brevets

(11) Publication number: **0 187 765**
**B1**

# EUROPEAN PATENT SPECIFICATION

(45) Date of publication of patent specification: **23.08.89**

(21) Application number: **85902624.7**

(22) Date of filing: **23.05.85**

(86) International application number:
**PCT/HU85/00032**

(87) International publication number:
**WO 85/05529 05.12.85 Gazette 85/26**

(51) Int. Cl.⁴: **H 05 K 3/42,** H 05 K 3/46, H 01 R 9/09

(54) **PROCESS TO INCREASE THE RELIABILITY OF THE METALLIZATION OF BORINGS IN THE PRODUCTION OF MULTILAYER PRINTED CIRCUITS.**

(30) Priority: **23.05.84 HU 199284**

(43) Date of publication of application:
**23.07.86 Bulletin 86/30**

(45) Publication of the grant of the patent:
**23.08.89 Bulletin 89/34**

(84) Designated Contracting States:
**AT BE CH DE FR GB IT LI LU NL SE**

(56) References cited:
**EP-A-0 052 738**
**EP-A-0 062 084**
**WO-A-81/01494**
**GB-A-2 057 195**
**GB-A-2 123 616**

(73) Proprietor: **MTA KÖZPONTI FIZIKAI KUTATO INTEZETE**
**29-33, Konkoly Thege ut**
**H-1121 Budapest (HU)**

(72) Inventor: **BANKI, Ferenc**
**Néphadsereg u.6**
**H-1055 Budapest (HU)**
Inventor: **LUKACS, József**
**Széher ut 40**
**H-1021 Budapest (HU)**
Inventor: **NYITRAI, Zoltán**
**Solyom ut 20**
**H-1126 Budapest (HU)**

(74) Representative: **Hoffmann, Klaus, Dr. rer. nat. et al**
**Hoffmann . Eitle & Partner Patentanwälte**
**Postfach 81 04 20 Arabellastrasse 4**
**D-8000 München 81 (DE)**

Courier Press, Leamington Spa, England.

## Description

The invention relates to a process for manufacturing metallized through-holes between different layers of a multilayer printed circuit board, preferably a four-layer printed circuit board wherein the two outer layers are used for signal leading and board connection and the inner layers are used for earthing and supply voltage circuits, respectively, said process comprising the steps of drilling the through-holes with a drill bit and coating them with a metal. Such a process is known from EP—A—0062 084.

Soon after the appearance of the mounting techniques of two-sided printed circuits a demand emerged to produce more than two layers placed collaterally. This was on the one hand necessary so that supply voltage and earthing connection could be arranged more conveniently and reliably, and on the other hand so that component density could be increased.

The contacts between components have two basic functions: to ensure a suitable supply voltage and earthing, and to conduct signals between the circuits. The diameter of the supply voltage and earthing leads is considerably greater than that of the signal leads.

Even when using two-sided printed wiring an effort has been made to separate the supply voltage and earthing leads. One of the most common ways is to supply the cards with separate rail contacts for the supply voltage and earthing. Thus the diameter of the leads is much greater and it is easier to plan the signal leads because the layers of the printed circuit are reserved exclusively for the latter. This solution, however, has not proved to be completely suitable, as mounting is difficult and a great deal of space is needed.

The appearance of printed circuits of more than two layers meant further progress. Four-layer printed circuits are the most common; in these the two inner layers take over the role of the supply voltage and earthing rails, the outer layers used for the signal leads. This solution has several advantages. The supply voltage and earthing leads can have a great surface area and at the same time a great diameter, but they do not take up any space on the mounting side, and it is thus easier to place the signal leads. A further advantage is that the surface layer ensures excellent screening between the two outer layers, and enables the signal leads on the outer surface to function as a sort of waveguide. This means that the circuits are faster and there is less noise.

Not only four, but printed circuits of more than four layers are also used, but these are much less common. Below we mainly discuss four-layer printed circuits, which have the supply voltage and earthing leads in the inner layers.

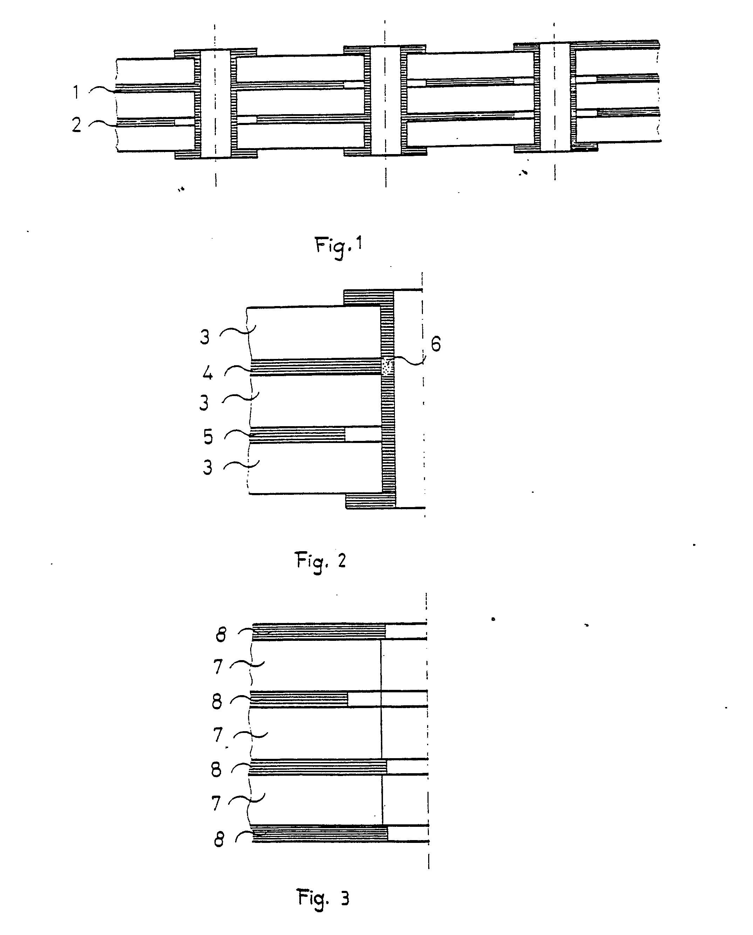

Contact between the layers of multilayer printed circuits is ensured by metallized borings. Metallized borings connect layers in which the conducting copper layer is in contact with the boring. If we want no contact, an insulator ring or insulator mash has to be put around the boring. Figure 1 shows the section of a four-layer printed card, with earthing (1) and supply voltage (2) in the inner layers. The shaded part symbolizes conducting metal layers. The metallized boring on the left side of the figure conducts the earthing lead to both outer layers, the boring in the middle the supply voltage lead. The boring at the far right has no contact either with the earthing or with the supply voltage lead, but connects the signal leads on the two outer layers of the printed circuit card. The thickness of the individual conducting layers is usually 35 micron, the diameter of the boring varies between 0.8 and 1.2 mm.

The most frequent cause of failure of multilayer printed circuits is a gap between the inner conducting layer and the metallized boring. This failure is highly inconvenient as it cannot be discovered by simple checking and, if there is a slight bend in the card, may not always be apparent. It is also inconvenient from the viewpoint of the ageing of the printed circuit card since such a gap can occur at any time as a consequence of normal mechanical use. This means that in industrial environments where a great degree of reliability is necessary, multilayer printed circuit cards are, even today, used with the utmost reserve.

The frequent gap between the inner conducting layer and the metallized boring is a consequence of present technology. Following the usual technology the cards forming the multilayer printed circuit are bonded together, and the borings made with an extremely hard, high speed rotation bit. The borings are first coated mechanically with a thin copper layer, and are then electroplated to make the copper layer thicker.

The fundamental problem of this technology is that during boring the basic insulator layer of the printed circuit card heats and smears. As the bore passes the middle, conducting layer, this smeared insulator material covers the latter, and in the next technological phase, the metallizing of the boring, there is insufficient contact between the metal coating and the middle conducting layer. The problem is aggravated by the fact that the usual thickness of this middle metal layer is no greater than about 35 micron, so even without smearing the two metal layers are connected only by means of a 35 micron high cylindrical jacket. Figure 2 shows an enlarged picture of a boring. The middle, earthing layer (4) is conducted through the insulator layers (3) to the two outer conducting layers. Smearing (6), however, increases the resistance between the two metal layers and could even insulate them completely.

Several methods have been elaborated to solve this technological problem. A common feature of these methods is that the smears are removed from the boring before the metallizing procedure. Older methods used chemical etching, but this is a health hazard and it is very difficult to determine the appropriate etching period. If this is too long the wall of the boring within the insulating material becomes coarse, leaving no smooth surface needed for metallizing. The latest method is to remove smeared insulating material by plasma etching, but this needs very expensive equipment. Another disadvantage of etching is that the copper becomes hard and brittle.

On the other hand, etching attacks and removes the insulator material, but not the metal itself. This means that after the etching, copper rises from the surface of the boring and touches the copper used for metallizing over a greater area. Figure 3 shows the boring of a four-layer printed circuit after etching and prior to boring. The figure shows that as a consequence of boring the insulator layers (7) are deeper than the conducting layers (8).

The object of our invention is to eliminate simultaneously all the difficulties mentioned above and to provide a process that ensures durable, reliable connection between one of the inner and one of the outer layers of a multilayered printed circuit card. Said object of this invention is thus to ensure durable, reliable contact between the outer and inner conducting layers when producing multilayer printed circuit cards. This object is solved in that at least one of the through-holes connecting one outer with one inner layer is, before being metallized, redrilled with a larger diameter from an appropriate side of the board up to the inner layer with an electronically controlled bit, whereby during drilling reaching of the inner layer is sensed and, after having reached a required depth within this layer, the forward movement of the bit is stopped, and furthermore in that after having made the necessary number of larger diameter drillings, the cylindrical jackets of the through-holes and the surfaces of the cones generated through said redrilling in the inner layers are coated with said metal, e.g. copper, in the known way.

The reliability of the metallized boring is ensured as contact with the middle layer is not only via the edges of the conducting layers, but via a greater surface area of the given conducting layer, and the effects of the smearing of the insulator material are eliminated.

The distinctive advantage of the process described in the invention is that the connection between the inner and outer layers is made more reliable by enlarging that part of the surface area of the inner layer that can be metallized. This is achieved by adding a further technical step to the usual process. After having made the borings in the usual way, those to be connected with one of the inner conducting layers and rebored with a greater diameter, not to their full length, but just up to the inner conducting layer. The same result is obtained if we start by first making the borings up to the inner conducting layer and after this the full-length borings with the usual diameter. The technical steps after this are the ones that are commonly used.

A further embodiment of the invention is characterized in that connecting the outer, e.g. the first and/or the fourth, and the inner, e.g. the second and/or the third layers, the drillings with the larger than usual diameter are made before making the drillings with the usual diameter.

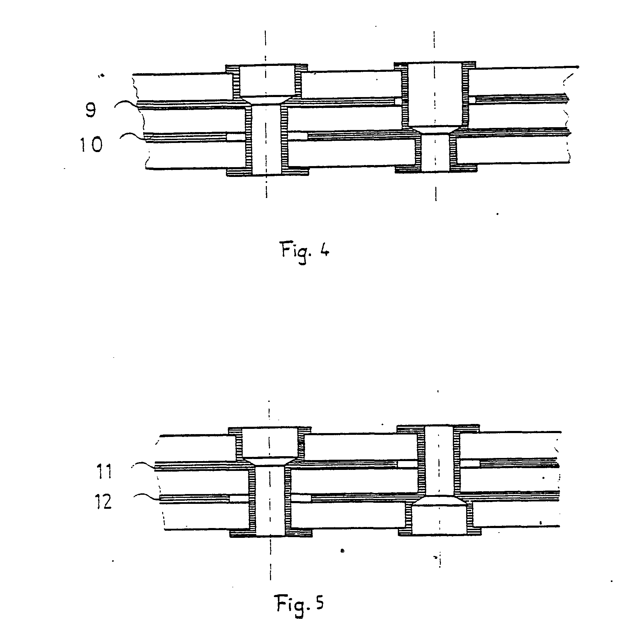

The intermediate technical step is shown in Fig. 4.

This figure shows a section of a four-layer printed circuit card, where the metallized boring on the left conducts the printed wiring of the earthing (9) to the two outer surfaces, while the boring to the right the supply voltage lead (10). For comparison, Figure 1 shows the usual solution, Figure 4 shows clearly that now the inner conducting layer and the metallized boring are connected not only by a 35 micron high cylindrical jacket, but also by an envelope of a cone which has a much greater surface area, and it also shows that if this envelope of a cone is used the likelihood of a smear of the insulator material is less, thereby increasing the reliability of the cards to a great extent.

Figure 5 shows the result of a variation to this process. Here the boring with greater diameter extends from the surface to the inner conducting layer, and the other one from the surface on the opposite side to another conducting layer.

Figure 7 shows the solution for printed circuits of more than four layers, when the inner layers also contain signal leads which have to be connected galvanically. In this case we can use the described process by boring from both sides up to the layers (18) and (19).

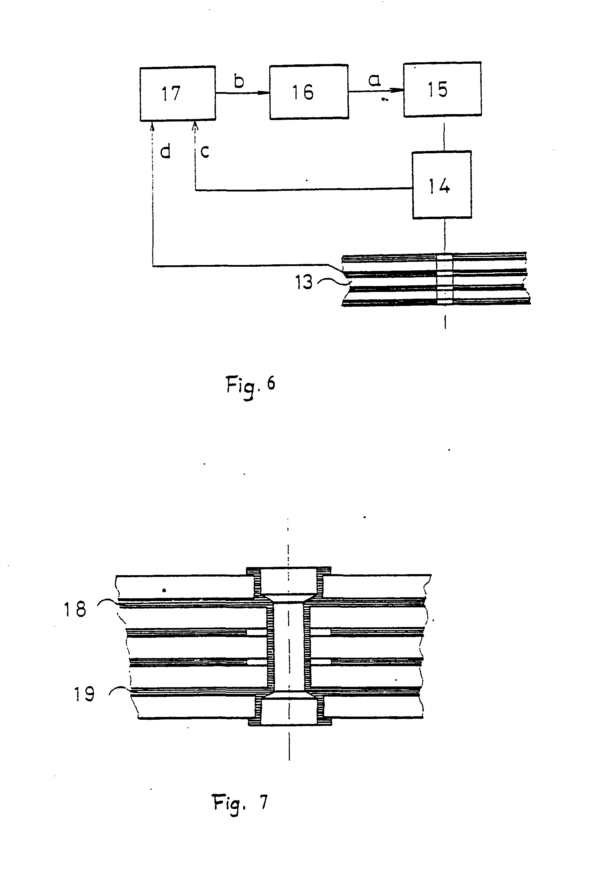

Figure 6 shows the arrangement of the equipment used in this process. The greatest problem is caused by the forward movement of the bit enlarging the boring having to be stopped very suddenly so as not to make the metal of the inner conducting layer too thin. According to the shown arrangement the bore is connected rigidly (14) with an electronically controlled device (15) pushing it forward. The electronic control (16) of this device (15) is activated by a sensor circuit (17) that senses contact between metals. As the two inner layers conduct supply voltage and earthing, these layers have outer connectors. If the resistance between these outer connectors and the bore decreases, the bore has reached the inner metal layer and this is sensed by the sensor circuit.

Other solutions are possible to control the forward movement of the bit. Instead of a sensor circuit sensing contact between the metals a sensor circuit sensing change in capacity could be used.

## Claims

1. A process for manufacturing metallized through-holes between different layers of a multilayer printed circuit board, preferably a four-layer printed circuit board wherein the two outer layers are used for signal leading and board connection and the inner layers are used for earthing and supply voltage circuits, respectively, said process comprising the steps of drilling the through-holes with a drill bit and coating them with a metal, and being characterized in that at least one of the through-holes connecting one outer with one inner layer is, before being metallized, redrilled with a larger diameter from an appropriate side of the board up to the inner layer with an electronically controlled bit, whereby during drilling reaching of the inner layer is sensed and, after having reached a required depth within this layer, the forward movement of the bit is stopped, and furthermore in that after having made the necessary number of larger diameter drillings, the cylindrical jackets of the through-holes and the surfaces of the cones generated through said redrilling in the inner layers are coated with said metal, e.g. copper, in the known way.

2. A process according to claim 1, characterized in that connecting the outer, e.g. the first and/or the fourth, and the inner, e.g. the second and/or the third layers, the drillings with the larger than usual diameter are made before making the drillings with the usual diameter.

## Patentansprüche

1. Verfahren zur Herstellung metallisierter Bohrungen zwischen verschiedenen Schichten einer Karte mit mehrschichtiger gedruckter Schaltung, vorzugsweise einer Karte mit vierschichtiger gedruckter Schaltung, von denen die zwei äußeren Schichten für die Signalführung sowie für den Anschluß der Karte und die inneren Schichten jeweils für die Erdung und für Spannungsversorgungsschaltungen vorgesehen sind, wobei das Verfahren Schritte zum Bohren der Bohrungen mit einem Spiralbohrer und zum Beschichten der Bohrungen mit einem Metall umfaßt, dadurch gekennzeichnet, daß wenigstens eine der Bohrungen, welche eine äußere mit einer inneren Schicht verbindet, vor der Metallisierung von einer geeigneten Seite der Karte aus bis zu der inneren Schicht mit einem elektronisch gesteuerten Bohrer auf einen größeren Durchmesser aufgebohrt wird, wobei während des Bohrens das Erreichen der inneren Schicht abgetastet und nach Erreichen einer erforderlichen Tiefe innerhalb dieser Schicht die Vortriebsbewegung des Bohrers angehalten wird, und daß nach Ausführung der notwendigen Anzahl von Bohrungen mit größerem Durchmesser die zylindrischen Mäntel der Bohrungen und die Flächen der durch dieses Aufbohren in den inneren Schichten gebildeten Konusse mit einem Metall, z. B. Kupfer, in bekannter Weise beschichtet werden.

2. Verfahren nach Anspruch 1, dadurch gekennzeichnet, daß zur Verbindung der äußeren, z. B. der ersten und/oder vierten, und der inneren Schichten, z. B. der zweiten und/oder dritten, die Bohrungen mit dem größeren als üblichen Durchmesser zuerst ausgeführt werden, bevor die Bohrungen mit dem üblichen Durchmesser ausgeführt werden.

## Revendications

1. Un procédé pour la fabrication de trous transversaux métallisés entre différentes couches d'une plaquette d'un circuit imprimé à plusieurs couches, de préférence une plaquette de circuit imprimé à quatre couches dans lequel les deux couches externes sont respectivement utilisées pour la conduite de signaux et le raccordement de la plaquette et les couches internes sont respectivement utilisées pour des circuits de mise à la terre et de tension d'alimentation, ledit procédé comprenant les étapes de perçage des trous transversaux avec un foret et de revêtement de ceux-ci avec un métal, et caractérisé en ce qu'au moins l'un des trous transversaux reliant une couche externe avec une couche interne est, avant d'être métallisé, repercé à un diamètre plus grand en partant d'un côté approprié de la plaquette jusqu'à la couche interne avec un foret commandé électroniquement, et en ce que, durant le perçage, le contact avec la couche interne est détecté, et après avoir atteint une profondeur nécessaire à l'intérieur de cette couche, le mouvement avant du foret est stoppé, et en outre en ce que, après avoir effectué le nombre nécessaire de perçages à diamètre plus grand, les gaines cylindriques des trous transversaux et les surfaces des cônes produits par ladite reperforation dans les couches internes sont revêtus dudit métal, par exemple, du cuivre, de la manière habituelle.

2. Un procédé selon la revendication 1, caractérisé en ce qu'en reliant la couche externe, par exemple la première et/ou la quatrième couche, et la couche interne, par exemple la seconde et/ou la troisième couche, les perçages à diamètre plus grand qu'usuellement sont réalisés avant les perçages à diamètre habituel.

1 〜

2 〜

**Fig. 1**

3 〜

4 〜

3 〜

5 〜

3 〜

6

**Fig. 2**

8 〜

7 〜

8 〜

7 〜

8 〜

7 〜

8 〜

**Fig. 3**

9

10

Fig. 4

11

12

Fig. 5

Fig. 6

Fig. 7